# EUROPEAN PATENT SPECIFICATION

(11) **EP 0 669 207 B1**
(45) Date of publication and mention of the grant of the patent: **01.07.1998**
(21) Application number: 95301200.2
(22) Date of filing: 23.02.1995
(51) Int. Cl.: B32B 27/08

(54) **A liquid crystal polymer film and a process for manufacture thereof**
Kunststofffilm aus Flüssigkristall und Verfahren zu seiner Herstellung
Film polymère à cristaux liquides et procédé pour sa production

(30) Priority: 23.02.1994 JP 47963/94
(43) Date of publication of application: 30.08.1995
(73) Proprietor: JAPAN GORE-TEX, INC., Setagaya-ku Tokyo-To 156 (JP)
(72) Inventor: Moriya, Akira, Okayama-shi, Odayama-ken 703 (JP)
(74) Representative: Shanks, Andrew

(56) References cited:
- EP-A- 0 232 422
- EP-A- 0 612 610
- WO-A-89/12548
- GB-A- 2 166 685
- US-A- 4 387 133
- DATABASE WPI Section Ch, Week 8628 Derwent Publications Ltd., London, GB; Class A85, AN 86-180932 & JP-A-61 116 331 ( SUMITOMO BAKELITE KK) , 3 June 1986

## Description

### FIELD OF THE INVENTION

The invention relates to liquid crystal polymer films and, more specifically, to thin oriented liquid crystal polymer films and to a method for producing them.

### BACKGROUND OF THE INVENTION

Liquid crystal polymers are a family of materials that exhibit a highly ordered structure in the melt, solution, and solid states. They can be broadly classified into two types; lyotropic, having liquid crystal properties in the solution state, and thermotropic, having liquid crystal properities in the melted state.

Most liquid crystal polymers exhibit excellent physical properties such as high strength, good heat resistance, low coefficient of thermal expansion, good electrical insulation characteristics, low moisture absorption, and are good barriers to gas flow. Such properties make them useful in a broad range of applications in the form of fibers, injection molded articles, and, in sheet form, as electronic materials for printed circuit boards, packaging, and the like.

However, many of the physical properties of liquid crystal polymers are very sensitive to the direction of orientation of the liquid crystal regions in the polymer. The ordered structure of the liquid crystal polymer is easily oriented by shear forces occurring during processing and highly aligned liquid crystal chains can be developed that are retained in the solid state, and result in highly anisotropic properties. This can be highly desirable for certain products, for example, in filaments, fibers, yarns, and the like. Anisotropic properties are often not desirable, however, in products having planar forms, such as tape, films, sheet and the like.

GB-A-2166685 describes methods for forming uniaxial laminate film comprising extruding a thermotropic liquid crystal from an anisotropic melt phase to form a film which is then extrusion laminated to a thermoplastic polymer having film forming ability. Alternatively, the laminate may be formed by fusion-forming the materials using a multi-layer inflation film device, and the resulting laminate sheet may be stretched biaxially. It is an object of GB-A-2166685 to provide sheets with uniaxial orientation with the anisotropy of the liquid crystal polymer preserved to provide strength in the direction of orientation.

A number of methods are used to produce liquid crystal polymer materials in planar forms that have more balanced, less anisotropic properties. These include the use of multilayer flat dies which are oriented such that they extrude overlapping layers at intersecting angles, use of static mixer-agitators at the die inlets, and the like. More recently, dies having rotating or counter-rotating surfaces have become known in the art and successfully used. These extrusion techniques, used separately or in combination with other methods known in the art, such as film blowing, can produce liquid crystal polymer film and sheet that are multiaxially oriented, that is, oriented in more than one direction, and have more balanced physical properties.

A characteristic of these methods is that locally, for example, at the surfaces of the sheet or film, the molecules are oriented in the planer x-y directions by shear imparted at the extrusion surfaces. In the z-direction, i.e. throughout the thickness, the x-y orientation of the molecules will change progressively from the orientation at one surface to the orientation at the other surface of the planar form. A drawback to these methods is that when attempting to make very thin multiaxially oriented films, e.g., films having a thickness of 25 micrometers or less, the forces imparted in the orientation transition region of the liquid crystal polymer by the extrusion surfaces are exerted in increasingly opposing directions as the distance between the extrusion surfaces diminishes and the formation of pinholes, tears, and other imperfections, for example, separation of surface layers of the film takes place.

W0-A-8912548 discloses film-based structural members prepared from lyotropic liquid crystalline polymers, that is polymers that form liquid crystal phases only when dissolved in a liquid solution and can only be oriented while in solution. The polymers therefore require very different processing to liquid crystal polymers having thermotropic characteristics.

### SUMMARY OF THE INVENTION

This invention provides a composite material comprising a multiaxially oriented thermotropic liquid cyrstal polymer film having a thickness of 25 micrometers or less.

Broadly speaking, the invention comprises the combination of a nonporous membrane of a synthetic polymer with a liquid crystal polymer to form a nonporous composite material in which, during the processing steps, the support membrane provides support to the liquid crystal polymer and is the medium by which the liquid crystal polymer is uniformly oriented throughout the film thickness and, at the same time, formed into a thin film on the surface of the support membrane.

It is recognized that "membrane" and "film" can often be used interchangeably, however, to avoid confusion, "membrane" will generally be used herein with respect to the nonporous support material; and "film" with respect to liquid crystal polymer material.

Liquid crystal polymer, as used herein, is meant to include polymer alloys having a liquid crystal polymer component as well as liquid crystal polymers alone. For convenience, the term "liquid crystal polymer" is used herein to include material of both kinds.

By multiaxially-oriented liquid crystal polymer, as used herein, is meant liquid crystal polymer material to which forces in more than one direction have been applied in order to orient the liquid crystal polymer.

An embodiment of the invention is a nonporous multiaxially-oriented composite material comprising:
(a) at least one stretched nonporous support membrane of synthetic polymer and
(b) at least one nonporous stretched oriented film of thermotropic liquid crystal polymer, said nonporous support membrane and said liquid crystal polymer film adhered together in laminar relationship to form a nonporous composite material,
   said composite material being co-stretched in at least two directions to multiaxially orient the liquid crystal polymer film; and
   said liquid crystal polymer film having a thickness of 25 micrometers or less.

Another embodiment of the invention is a process for producing a nonporous multiaxially-oriented liquid crystal polymer film comprising the steps of:
(a) adhering a thermotropic liquid crystal polymer film to at least one nonporous support membrane of synthetic polymer;
(b) heating the composite material obtained in step (a) while under tension to a temperature above the melt point of the liquid crystal polymer;
(c) stretching the heated composite material of step (b) in at least two directions while maintaining the temperature at or above the melt point of the liquid crystal polymer to multiaxially orient the liquid crystal polymer, and
(d) cooling the product of step (c).

### DETAILED DESCRIPTION OF THE INVENTION

Longitudinal direction, x-direction, and machine direction (MD) as used herein indicate the planar direction of manufacture of a film or sheet; transverse direction (TD) and y-direction indicate the planar direction normal to the direction of manufacture.

Materials for the support membrane of the invention are selected on the basis of their ability to withstand the forces and temperatures of processing, on their ability to be stretched, and on their chemical resistance to the liquid crystal polymers and solutions with which they are combined. The support membrane is preferably made of a synthetic polymer and is nonporous. Suitable synthetic polymers for nonporous support membranes include thermoplastic polyimides, polyethersulfones, and polyethylene terephthalates.

Thermotropic liquid crystal polymers can be used as the liquid crystal polymer of the invention. Examples of suitable thermotropic liquid crystal polymers include aromatic polyesters which exhibit liquid crystal properties when melted and which are synthesized from aromatic diols, aromatic carboxylic acids, hydroxycarboxylic acids, and other like monomers. Typical examples include a first type consisting of parahydroxybenzoic acid (PHB), terephthalic acid, and biphenol; a second type consisting of PHB and 2,6-hydroxynaphthoic acid; and a third type consisting of PHB, terephthalic acid, and ethylene glycol. They are represented below as Formulas 1, 2, and 3 respectively.

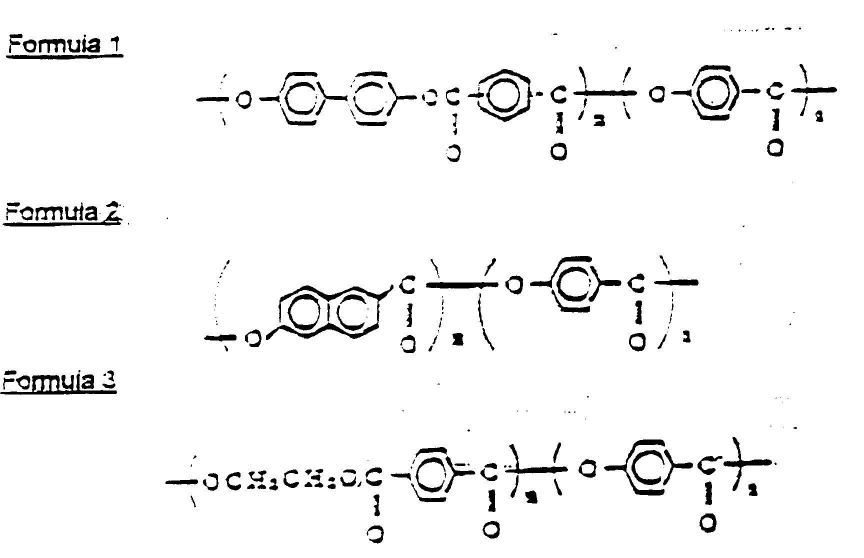

Also, in the present invention, a polymer alloy having a liquid crystal polymer component can be used. In such cases the polymer which is mixed with or chemically bonded to a liquid crystal polymer can be selected from the group consisting of, but not limited to, polyetheretherketones, polyether sulfones, polyimides, polyether imides, polyamides, polyamidoimides, polyallylates, polyacrylates, and the like. The polymers and liquid crystal polymer components are mixed in a weight ratio of 10:90 to 90:10, preferably in the range of 30:70 to 70:30.

The liquid crystal polymers and polymer alloys described hereinabove are meant for illustration and not for limitation of the invention. It is recognized by the inventor that many other liquid crystal polymers and polymer alloys suitable for use in the invention are known in the art. Likewise, it is recognized that compatibilizers, plasticizers, flame retardant agents, and other additives may be contained in the liquid crystal polymers of the invention.

In one embodiment of the invention a composite material is formed by applying a melt-processible thermotropic liquid crystal polymer film to the surface of a support membrane, for example, a liquid crystal polymer film separately produced by one of the methods described earlier. The liquid crystal polymer may also be applied by direct extrusion on to the surface of the support membrane by methods well known in the art. The applied liquid crystal polymer film should have a thickness in the range 50 to 1000 micrometers, preferably in the range 100 to 500 micrometers.

The thermotropic liquid crystal polymer film is adhered to the support membrane using conventional lamination methods, for example, by application of heat and pressure by heated platens, or by passage through the nip of heated calender rolls. Typically, the temperature of the platens or rolls are in the range 10 to 50°C higher than the melt point of the thermotropic liquid crystal polymer. Good bonding of the liquid crystal polymer film to the support membrane is necessary in order to ensure that in the subsequent stretching step the liquid crystal polymer will move with and be oriented by the support membrane as it is stretched. If desired, a second support membrane may be laminated in like manner to the other side of the liquid crystal polymer film, thus forming a sandwich structure comprising a liquid crystal polymer film between two layers of support membrane. Alternatively, multiple alternating layers of liquid crystal polymer film and support membranes may be laminated together to form the composite material.

The composite material formed of the thermotropic liquid crystal polymer film and support membrane is then heated to a temperature at or above the melt point of the liquid crystal polymer and stretched in at least two directions. Stretching in at least two directions may be done simultaneously or sequentially, and may be done in one or more steps. The amount of stretch, relative, to original dimensions in the planar x-y directions or radial directions, is ordinarily in the range 1.5 to 15:1, preferably in the range 4 to 8:1. The rate of stretch is generally in the range 5% to 500% per minute, preferably in the range 20% to 100% per minute; at a speed generally in the range 0.2 to 10 meters/minute, preferably in the range 1 to 6 meters/minute.

Stretching may be done using conventional equipment or apparatus known in the art. For example, multiaxial simultaneous stretching can be done using a radial stretching pantograph; and biaxial stretching in the planar x-y directions can be done, simultaneously or sequentially, using an x-y direction stretching pantograph. Also, uniaxial stretching equipment can be used sequentially, for example, differential speed rolls for stretching in the machine direction (MD) and tenter frames for stretching in the transverse direction (TD).

As the support membrane is stretched in the planar x-y directions the area of its surface progressively increases and its thickness is progressively reduced. The melted liquid crystal polymer film, bonded to and supported by the support membrane, is also stretched by the stretching membrane, also increases in area in the planar x-y directions, and the liquid crystal regions of the film become uniformly oriented from one planar surface to the other as well as in the x-y directions by the stretching. The liquid crystal polymer film thus produced has virtually no orientation gradient or orientation layering effects in the z-direction, i.e., through its thickness. At the same time, as there is no change in the volume of liquid crystal polymer, the liquid crystal polymer film becomes progressively thinner as the material of the film is dragged and spread by the stretching membrane.

By controlling the amount of stretch, rate of stretch and directions of stretch of the composite material, the liquid crystals can be aligned in a preferred orientation, or aligned multiaxially and more randomly to provide relatively balanced physical properties. In general, liquid crystal polymer films having balanced physical properties are very useful, in particular, for electronic applications such as printed circuit boards, and are preferred. By controlling the amount of liquid crystal polymer initially adhered to the support membrane, i.e., by using thicker or thinner starting films, and adjusting the amount of stretch to provide the desired increase in planar surface area, the thickness of the liquid crystal polymer film is reduced to 25 micrometers or less, and can be as thin as 2 micrometers. Furthermore, the liquid crystal polymer film or layer remains intact, does not have holes or tears, has a very uniform thickness, is uniformly oriented from one planar surface to the other, and has a remarkably smooth surface.

After the stretching step the composite material should be heat treated to stabilize the physical properties and reduce strains In the liquid crystal polymer. The heat treatment is done with the material restrained to prevent shrinking. Heat treatment temperature will vary according to the thermotropic liquid crystal polymer used, but is generally in the range from slightly above the crystallizing point to slightly below the melt range of the liquid crystal polymer.

The nonporous composite materials of the invention comprising multiaxially oriented liquid crystal polymer films or layers, produced as described above and which are oriented so as to provide relatively balanced physical properties, are thin and light in weight and, furthermore, have strength, flexibility, thermal expansion, and liquid and gas barrier characteristics that make them highly desirable for use as printed circuit board and other electronic substrates, and the like.

### TEST DESCRIPTIONS

### Tensile Test

Tensile strength and tensile elongation were measured in accordance with Japanese Industrial Standard JIS K 7127.

Measurement values are given in kg/mm², and are shown in Table 1.

### Surface Roughness

Surface roughness was measured by a profilometer, Model SURFCOM 570A or Model SURFCOM 1500A, made by Tokyo Seimitsu Co.

Roughness units, Ra, are given in micrometers and, in accordance with Japanese Industry Standard JIS B0601, represent the arithmetic mean of the absolute value of the deviation from the center line.

### Surface Layer Separation

The sample surface is softly rubbed with sandpaper and examined visually to determine it fibers have been created or raised from the surface. The results are reported simply as "yes" (fibers present) or "no" (no fibers present).

### Example 1

A thermotropic liquid crystal polymer (Vectra® A-950 resin, supplied by Polyplastics Co.) was extruded and blown at a ratio of 1.2:1 to provide a film 110 micrometers thick. A 50 mm diameter uniaxial screw extruder with a rotating die (Type 304 SS) having a 100 mm office was used. Extrusion conditions were: die rotation rate - 7 RPM; die temperature - 300°C; takeup rate - 2 m/min.

A nonporous polyethersulfone membrane having a thickness of 50 micrometers was adhered to each side of the thermotropic liquid crystal polymer film. The materials were laminated by application of heat and pressure by passage through the nip between metal rolls heated to 330°C at an applied pressure of about 3 kg/cm.

The laminate thus formed was mounted in a biaxial (x-y direction) stretching pantograph, heated to a temperature in its melt range, and stretched in two directions. The composite material was stretched an amount of 4:1 in each direction, at a stretch rate of 100%/min., and at a temperature of 295°C. Stretching in each direction was done sequentially. The composite stretched material was then heat treated at a temperature of 240°C for 3 minutes while restrained from shrinking.

A nonporous composite material of the invention having a thickness of 10 micrometers was produced.

The material was examined and found to not have tears or holes. Samples were prepared for tensile tests, surface roughness measurements, and surface layer separation tests. Surface roughness measurements and surface layer separation tests were made on the liquid crystal polymer film surface after removal of the support membrane from the liquid crystal polymer film surface. The test results are shown in Table 1.

### Comparative Example 1

A thermotropic liquid crystal polymer film of Vectra A-950 resin was made as described in Example 1, except that no support membrane was used, to make a film having a thickness of 50 micrometers. The film was then biaxially stretched as described in Example 1.

The stretched film had numerous tears and holes, and was not suitable for further testing.

### Comparative Example 2

A thermotropic liquid crystal polymer (Vectra® A-950 resin, supplied by Polyplastic Co.) was extruded and blown at a ratio of 1.2:1 to provide a film 50 micrometers thick. A 50 mm diameter uniaxial screw extruder with a rotating die (Type 304 SS) having a 100 mm orifice was used. Extrusion conditions were: die rotation rate - 30 RPM; die temperature - 300°C; takeup rate - 10 m/min. The film was not stretched.

The film was examined and found to not have tears or holes. Samples were prepared for tensile tests, surface roughness measurements, and surface layer separation tests. The test results are shown in Table 1.

### Comparative Example 3

A thermotropic liquid crystal polymer film of Vectra A-950 resin was made as described in Comparative Example 2, except that a die having a lip surface of tantalum (5 mm thick) was used. The film was not stretched.

The film was examined and found to not have tears or holes. Samples were prepared for tensile tests, surface roughness measurements, and surface layer separation tests. The test results are shown in Table 1.

**TABLE 1**

| | Thickness µm | Tears | Surface Layer Separation | Surface Roughness, µm | Tensile Strength (kg/mm²) | | Elongation percent | |
|---|---|---|---|---|---|---|---|---|
| | | | | | MD | TD | MD | TD |
| Example 1 | 10 | none | No | 0.03 | 27 | 26 | 3 | 3 |
| Comp. Ex. 1 | - | many | n/a | - | - | - | - | - |
| Comp. Ex. 2 | 50 | none | Yes | 2.4 | 15 | 13 | 7 | 8 |
| Comp. Ex. 3 | 50 | none | Yes | 2.4 | 16 | 14 | 7 | 8 |

## Claims

1. A nonporous multiaxially-oriented composite material comprising:
(a) at least one stretched nonporous support membrane of synthetic polymer and
(b) at least one nonporous stretched oriented film of thermotropic liquid crystal polymer, said nonporous support membrane and said liquid crystal polymer film adhered together in laminar relationship to form a nonporous composite material,
said composite material being co-stretched in at least two directions to multiaxially orient the liquid crystal polymer film; and
said liquid crystal polymer film having a thickness of 25 micrometers or less.

2. The composite material as recited in claim 1, wherein the multiaxially oriented liquid crystal polymer layer has a thickness of 10 micrometers or less.

3. The composite material as recited in claim 1, wherein the nonporous support membrane is polyethersulfone.

4. The composite material as recited in claim 2, wherein the nonporous support membrane is polyethersulfone.

5. A process for producing a nonporous multiaxially-oriented liquid crystal polymer film comprising the steps of:
(a) adhering a thermotropic liquid crystal polymer film in laminar relationship to at least one nonporous support membrane of synthetic polymer;
(b) heating the material obtained in step (a) while under tension to a temperature above the melt point of the liquid crystal polymer;
(c) stretching the heated material of step (b) in at least two directions while maintaining the temperature at or above the melt point of the liquid crystal polymer, thereby imparting multiaxial orientation to the liquid crystal polymer; and
(d) cooling the product of step (c).

6. The process as recited in claim 5, wherein the support membrane is a nonporous polyethersulfone membrane.

## Patentansprüche

1. Nicht-poröser, mehrachsig orientierter Verbundstoff, umfassend:
(a) mindestens eine gestreckte, nicht-poröse Trägermembran aus Synthetik-Polymer, und
(b) mindestens einen nicht-porösen gestreckten, orientierten Film aus thermotrophem Flüssigkristallpolymer, wobei die nichtporöse Trägermembran und der Flüssigkristallpolymer-Film zur Bildung eines nicht-porösen Verbundstoffs in einer laminaren Beziehung zusammenhaften,
wobei der Verbundstoff in mindestens zwei Richtungen gemeinsam gestreckt ist, um den Flüssigkristallpolymer-Film mehraxial zu orientieren; und
der Flüssigkristallpolymer-Film eine Dicke von 25 µm oder weniger besitzt.

2. Verbundstoff nach Anspruch 1, bei dem die mehraxial orientierte Flüssigkristallpolymer-Schicht eine Dicke von 10 µm oder darunter besitzt.

3. Verbundstoff nach Anspruch 1, bei dem die nicht-poröse Trägermembran Polyethersulfon ist.

4. Verbundstoff nach Anspruch 2, bei dem die nicht-poröse Trägermembran Polyethersulfon ist.

5. Verfahren zum Herstellen eines nicht-porösen, mehrachsig orientierten Flüssigkristallpolymer-Films, umfassend die Schritte:
(a) Anheften eines thermotropen Flussigkristallpolymer-Films in laminarer Beziehung an mindestens eine nicht-poröse Trägermembran aus Synthetikpolymer;
(b) Erhitzen des im Schritt (a) erhaltenen Materials unter Spannung auf eine Temperatur oberhalb des Schmelzpunkts des Flüssigkristallpolymers;
(c) Strecken des erhitzten Materials gemäß Schritt (b) in mindestens zwei Richtungen, während die Temperatur auf dem oder oberhalb des Schmelzpunkts des Flüssigkristallpolymers gehalten wird, um dadurch dem Flüssigkristallpolymer eine mehraxiale Orientierung zu verleihen; und
(d) Abkühlen des Produkts aus Schritt (c).

6. Verfahren nach Anspruch 5, bei dem die Trägermembran eine nichtporöse Polyethersulfon-Membran ist.

## Revendications

1. Matériau composite non poreux à orientation multiaxiale qui comprend:
(a) au moins une membrane support, non poreuse, étirée en polymère synthétique,
(b) au moins un film non poreux étiré orienté d'un polymère mésomorphe thermotrope, ladite membrane support non poreuse et ledit film de polymère mésomorphe étant maintenus ensemble dans un rapport laminaire pour former un matériau composite non poreux,
ledit matériau composite étant co-étiré dans au moins deux directions pour orienter multiaxialement le film de polymère mésomorphe; et
ledit film de polymère mésomorphe ayant une épaisseur de 25 micromètres ou moins.

2. Matériau composite selon la revendication 1, dans lequel la couche de polymère mésomorphe orientée multiaxialement possède une épaisseur de 10 micromètres ou moins.

3. Matériau composite selon la revendication 1, dans lequel la membrane support non poreuse est en polyéthersulfone.

4. Matériau composite selon la revendication 2, dans lequel la membrane support non poreuse est en polyéthersulfone.

5. Procédé pour la production d'un film de polymère mésomorphe non poreux à orientation multiaxiale comprenant les étapes qui consistent à:
(a) faire adhérer un film de polymère mésomorphe thermotrope dans un rapport laminaire à au moins une membrane support non poreuse de polymère synthétique;
(b) chauffer le matériau obtenu dans l'étape (a), tandis qu'il est sous tension, à une température au- dessus du point de fusion du polymère mésomorphe;
(c) étirer le matériau chauffé de l'étape (b) dans au moins deux directions tout en maintenant la température au niveau du point de fusion du polymère mésomorphe ou au-dessus de celui-ci, pour conférer ainsi une orientation multiaxiale au polymère mésomorphe; et
(d) refroidir le produit de l'étape (c).

6. Procédé selon la revendication 5, dans lequel la membrane support est une membrane non poreuse de polyéthersulfone.
